# EUROPEAN PATENT SPECIFICATION

(11) **EP 4 348 651 B1**
(45) Date of publication and mention of the grant of the patent: **02.04.2025**
(21) Application number: 21795151.6
(22) Date of filing: 27.09.2021
(51) Int. Cl.: G11C 16/04, G11C 16/10, G11C 16/34, G11C 11/56

(54) **METHOD OF IMPROVING READ CURRENT STABILITY IN ANALOG NON-VOLATILE MEMORY BY POST-PROGRAM TUNING FOR MEMORY CELLS EXHIBITING RANDOM TELEGRAPH NOISE**
VERFAHREN ZUR VERBESSERUNG DER LESESTROMSTABILITÄT IN EINEM ANALOGEN NICHTFLÜCHTIGEN SPEICHER DURCH NACHPROGRAMMIERUNGSABSTIMMUNG VON SPEICHERZELLEN MIT ZUFÄLLIGEM TELEGRAFISCHEM RAUSCHEN
PROCÉDÉ D'AMÉLIORATION DE LA STABILITÉ DE COURANT DE LECTURE DANS UNE MÉMOIRE NON VOLATILE ANALOGIQUE PAR RÉGLAGE POST-PROGRAMME POUR DES CELLULES DE MÉMOIRE PRÉSENTANT UN BRUIT DE TÉLÉGRAPHE ALÉATOIRE

(30) Priority: 02.06.2021 US 202163196130 P; 21.09.2021 US 202117481225
(43) Date of publication of application: 10.04.2024
(73) Proprietor: Silicon Storage Technology, Inc., San Jose, CA 95134 (US)
(72) Inventor: MARKOV, Viktor, Santa Clara, California 95050 (US); KOTOV, Alexander, San Jose, California 95127 (US)
(74) Representative: Betten & Resch
(86) International application number: PCT/US2021/052234
(87) International publication number: WO 2022/256030

(56) References cited:
- WO-A1-2021/045934
- US-B1- 8 908 441

## Description

### RELATED APPLICATIONS

This application claims the benefit of U.S. Provisional Application No. 63/196,130, filed June 2, 2021, and, U.S. Patent Application No. 17/481,225, filed on September 21, 2021.

### FIELD OF THE INVENTION

The present invention relates to non-volatile memory devices, and more particularly to improving the stability of memory cell current during read operations.

### BACKGROUND OF THE INVENTION

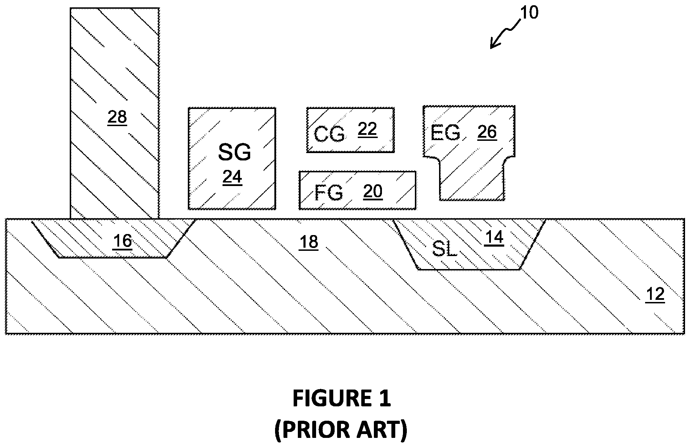

Non-volatile memory devices are well known in the art. See for example U.S. Patent 7,868,375, which discloses a four-gate memory cell configuration. Specifically, Fig. 1 of the present application illustrates a split gate memory cell 10 with spaced apart source and drain regions 14/16 formed in a silicon semiconductor substrate 12. The source region 14 can be referred to as a source line SL (because it commonly is connected to other source regions for other memory cells in the same row or column), and the drain region 16 is commonly connected to a bit line by a bit line contact 28. A channel region 18 of the substrate is defined between the source/drain regions 14/16. A floating gate 20 is disposed vertically over and insulated from (and controls the conductivity of) a first portion of the channel region 18 (and partially vertically over and insulated from the source region 14). A control gate 22 is disposed vertically over and insulated from the floating gate 20. A select gate 24 is disposed vertically over and insulated from (and controls the conductivity of) a second portion of the channel region 18. An erase gate 26 is disposed vertically over and insulated from the source region 14 and is laterally adjacent to the floating gate 20. A plurality of such memory cells can be arranged in rows and columns to form a memory cell array.

Various combinations of voltages are applied to the control gate 22, select gate 24, erase gate 26 and/or source and drain regions 14/16, to program the split gate memory cell 10 (i.e., inject electrons onto the floating gate), to erase the split gate memory cell 10 (i.e., remove electrons from the floating gate), and to read the split gate memory cell 10 (i.e., measure or detect the conductivity of the channel region 18 to determine the programming state of the floating gate 20).

Split gate memory cell 10 can be operated in a digital manner, where the split gate memory cell 10 is set to one of only two possible states: a programmed state and an erased state. The split gate memory cell 10 is erased by placing a high positive voltage on the erase gate 26, and optionally a negative voltage on the control gate 22, to induce tunneling of electrons from the floating gate 20 to the erase gate 26 (leaving the floating gate 20 in a more positively charged state - the erased state). Split gate memory cell 10 can be programmed by placing positive voltages on the control gate 22, erase gate 26, select gate 24 and source region 14, and a current on drain region 16. Electrons will then flow along the channel region 18 from the drain region 16 toward the source region 14, with electrons becoming accelerated and heated whereby some of them are injected onto the floating gate 20 by hotelectron injection (leaving the floating gate 20 in a more negatively charged state - the programmed state). Split gate memory cell 10 can be read by placing positive voltages on the select gate 24 (turning on the portion of channel region 18 under the select gate 24) and drain region 16 (and optionally on the erase gate 26 and/or the control gate 22), and sensing current flow through the channel region 18. If the floating gate 20 is positively charged (i.e. split gate memory cell 10 is erased), the split gate memory cell 10 will turn on, and electrical current will flow from drain region 16 to source region 14 (i.e. the split gate memory cell 10 is sensed to be in its erased "1" state based on sensed current flow). If the floating gate 20 is negatively charged (i.e. split gate memory cell 10 is programmed), the portion of channel region 18 under the floating gate is turned off, thereby preventing appreciable current flow (i.e., the split gate memory cell 10 is sensed to be in its programmed "0" state based on no, or minimal, current flow).

Table 1 provides non-limiting examples of erase, program and read voltages, where Vcc is power supply voltage or another positive voltage such as 2.5 V.

**Table 1**

| | **WL (SG)** | **BL (Drain)** | **Source** | **EG** | **CG** |
|---|---|---|---|---|---|
| **Erase** | 0V | 0V | 0V | 11.5V | 0V |
| **Program** | 1V | 1µA | 4.5V | 4.5V | 10.5V |
| **Read** | Vcc | 0.6V | 0V | 0V | Vcc |

Split gate memory cell 10 can alternately be operated in an analog manner where the memory state (i.e. the amount of charge, such as the number of electrons, on the floating gate 20) of the split gate memory cell 10 can be continuously changed anywhere from a fully erased state (minimum number of electrons on the floating gate 20) to a fully programmed state (maximum number of electrons on the floating gate 20), or just a portion of this range. This means the split gate memory cell 10 storage is analog, which allows for very precise and individual tuning of each split gate memory cell 10 in an array of split gate memory cells 10. Alternatively, the split gate memory cell 10 could be operated as an MLC (multilevel cell) where it is configured to be programmed to one of many discrete values (such as 16 or 64 different values). In the case of analog or MLC programming, the programming voltages are applied for a limited time, or as a series of pulses, until the desired programming state is achieved. In the case of multiple programming pulses, intervening read operations between programming pulses can be used to determine if the desired programming state has been achieved (in which case programming ceases) or has not been achieved (in which case programming continues).

Split gate memory cell 10 operated in an analog manner or as an MLC may be more sensitive to noise and read current instabilities which can adversely affect the accuracy of the split gate memory cell 10. One source of read current instability in analog non-volatile memory devices is the capture and emission of electrons by oxide traps located at the interface and near-interface between the gate oxide and memory cell channel region. The gate oxide is the insulation layer that separates the floating gate 20 from the channel region 18 of substrate 12. When an electron is captured on an interface trap, it reduces the channel conductivity during a read operation, and thus increases the threshold voltage Vt of the split gate memory cell 10 (i.e., the minimum voltage on the control gate 22 needed to turn on the channel region 18 of the split gate memory cell 10 to produce a predetermined target current, 1 µA being an example). When the control gate voltage is at or above the threshold voltage Vt, a conducting path is created between the source region 14 and the drain region 16, and a current of at least the predetermined target current flows. When the control gate voltage is below the threshold voltage Vt, a conducting path is not created, and any current between the source region 14 and the drain region 16 is considered sub-threshold or leakage current. An electron captured on an interface trap can be emitted from the interface trap, which decreases threshold voltage Vt of the memory cell, and thus increases the channel conductivity during a read operation. These single-electron events of electron capture and emission by interface traps appear as read current noise and are referred to as random telegraph noise (RTN). In general, RTN produced by a single interface trap is characterized by two states: a lower Vt state (and higher read current state) when an electron is emitted from the interface trap and a higher Vt state (and lower read current state) when an electron is captured by the interface trap. As described above, the instability of the split gate memory cell 10 during read can be characterized either by the threshold voltage Vt, i.e. the control gate voltage corresponding to the predetermined target current or by memory cell current under given read voltage conditions. The present examples are particularly described in relation to memory cell read instability as threshold voltage Vt, however the use of memory cell current under given read voltages are specifically contemplated.

Document WO2021/045934 A1 discloses a memory device that includes a plurality of non-volatile memory cells and a controller. The controller is configured to erase the plurality of memory cells, program each of the memory cells, and for each of the memory cells, measure a threshold voltage applied to the memory cell corresponding to a target current through the memory cell in a first read operation, re-measure a threshold voltage applied to the memory cell corresponding to the target current through the memory cell in a second read operation, and identify the memory cell as defective if a difference between the measured threshold voltage and the re-measured threshold voltage exceeds a predetermined amount.

Document US 8908441 B1 discloses memory cells which having read noise being identified during a programming pass and an amount of programming being increased for noisy memory cells compared to non-noisy cells. The read noise is indicated by a decrease in the threshold voltage of a cell when the cell is repeatedly read. In one approach, during the programming pass, a cell enters a temporary lockout state when it passes a first verify test and is subject to one or more additional verify tests. Data is stored to identify the cell as a noisy cell or a non-noisy cell based on the one or more additional verify tests. Or, the cells are subject to the one or more additional verify tests at the end of the programming pass. In a subsequent programming pass, the noisy cell is programmed using a stricter verify condition. Or, the noisy cell is kept in an erased state.

RTN that occurs during programming can be addressed as part of the program operation. However, one issue with RTN is that electron emission that undesirably decreases the threshold voltage Vt of the memory cell (and therefore undesirably increases channel conductivity during a read operation) can occur after programming of the memory cell is completed. Therefore, there is a need to address RTN in analog and MLC non-volatile memory devices, such as split gate memory cell 10, without limitation, to compensate for post-program RTN.

### BRIEF SUMMARY OF THE INVENTION

The aforementioned problems and needs are addressed by a memory device that comprises a plurality of non-volatile memory cells each comprising a first gate, and a control circuitry. The control circuitry is configured to:
program a selected non-volatile memory cell of the plurality of non-volatile memory cells to an initial program state that corresponds to a threshold voltage for the first gate of the selected non-volatile memory cell meeting or exceeding a target threshold voltage for the first gate of the selected non-volatile memory cell, wherein the target threshold voltage for the first gate corresponds to a target read current,
   wherein the programing of the selected non-volatile memory cell includes apply a program voltage having a first value to the first gate,
store the first value in a memory,
read the selected non-volatile memory cell in a first read operation using a read voltage applied to the first gate of the selected non-volatile memory cell that is less than the target threshold voltage for the first gate to generate a first read current, and
subject the selected non-volatile memory cell to additional programming in response to a determination that the first read current is greater than the target read current, wherein the additional programming comprises:
   retrieve the first value from the memory,
   determine a second value greater than the first value, and
   program the selected non-volatile memory cell that includes applying a program voltage having the second value to the first gate.

A method of programming a selected non-volatile memory cell of a plurality of non-volatile memory cells, wherein each of the plurality of non-volatile memory cells includes a first gate, the method comprising:
programming the selected non-volatile memory cell to an initial program state that corresponds to meeting or exceeding a target threshold voltage for the first gate of the selected non-volatile memory cell, wherein the target threshold voltage corresponds to a target read current, wherein the programing includes applying a program voltage having a first value to the first gate,
storing the first value in a memory,
reading the selected non-volatile memory cell in a first read operation using a read voltage applied to the first gate of the selected non-volatile memory cell that is less than the target threshold voltage to generate a first read current, and
subjecting the selected non-volatile memory cell to additional programming in response to determining that the first read current is greater than the target read current, wherein the additional programming comprises:
   retrieving the first value from the memory,
   determining a second value greater than the first value, and
   programming the selected non-volatile memory cell that includes applying a program voltage having the second value to the first gate.

Other objects and features will become apparent by a review of the specification, claims and appended figures.

### BRIEF DESCRIPTION OF THE DRAWINGS

Fig. 1 is a side cross sectional view of a conventional memory cell.
Fig. 2 is a diagram illustrating the components of a memory device.
Fig. 3 is a flow diagram showing steps for programming memory cells.
Fig. 4 is a flow diagram showing steps for post-program tuning of memory cells.
Fig. 5 is a flow diagram showing steps of a first alternate example for post-program tuning of memory cells.

### DETAILED DESCRIPTION OF THE INVENTION

The present examples illustrate a technique for compensating RTN after programming of non-volatile memory cells, such as the split gate memory cell 10 of Fig. 1 is completed, by performing post-program tuning to improve read operation accuracy.

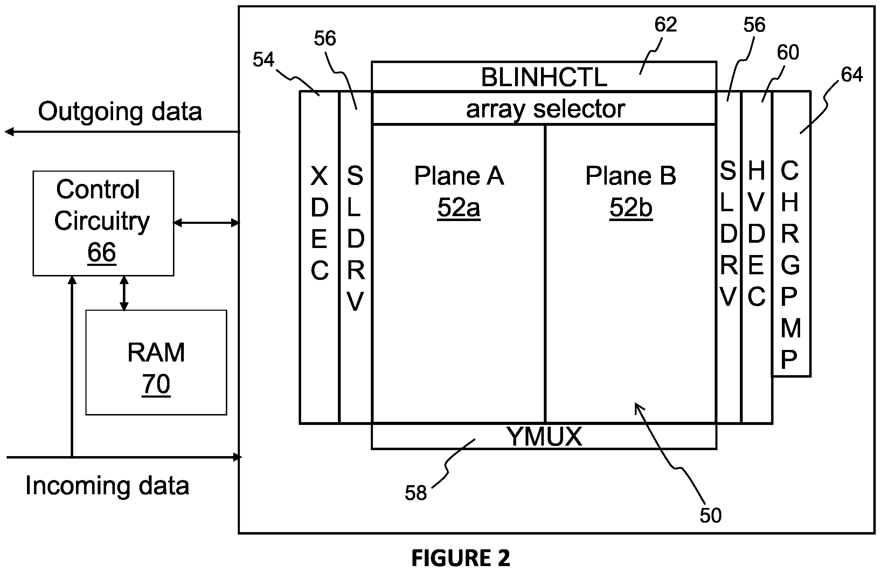

The memory cell programming and post-program tuning techniques are implemented as part of the configuration of the control circuitry 66, which controls the various device elements for the memory array, which can be better understood from the architecture of an example memory device as illustrated in Fig. 2. The memory device includes an array 50 of the split gate memory cells 10, which can be segregated into two separate planes (Plane A 52a and Plane B 52b). The split gate memory cells 10 can be of the type shown in Fig. 1, arranged in a plurality of rows and columns in the semiconductor substrate 12, and thus formed on a single chip. Adjacent to the array of array 50 of split gate memory cells 10 are an address decoder (e.g. XDEC 54), source line drivers (e.g. SLDRV 56), a column decoder (e.g. YMUX 58), a high voltage row decoder (e.g. HVDEC 60) and a bit line controller (e.g. BLINHCTL 62), which are used to decode addresses and supply the various voltages to the various gates and regions of the split gate memory cells 10 during read, program, and erase operations for selected split gate memory cells 10 of the array 50. Column decoder 58 includes a sense amplifier containing circuitry for measuring the currents on the bit lines during a read operation. Control circuitry 66 is configured to control the various device elements to implement each operation (program, erase, read) on selected split gate memory cells 10 of the array 50 as described herein. Charge pump CHRGPMP 64 provides the various voltages used to read, program and erase the selected split gate memory cells 10 of the array 50 under the control of the control circuitry 66. Control circuitry 66 is configured to operate the memory device to program, erase and read the selected split gate memory cells 10 of the array 50. As part of these operations, the control circuitry 66 can be provided with access to incoming data which is data to be programmed to the selected split gate memory cells 10 of the array 50, along with program, erase and read commands provided on the same or different lines. Data read from the array 50, i.e. from selected split gate memory cells 10 of the array 50. is provided as outgoing data. The control circuitry 66 includes, or is provided access to, a separate memory such as random access memory (RAM) 70 for storing voltage values as described further below.

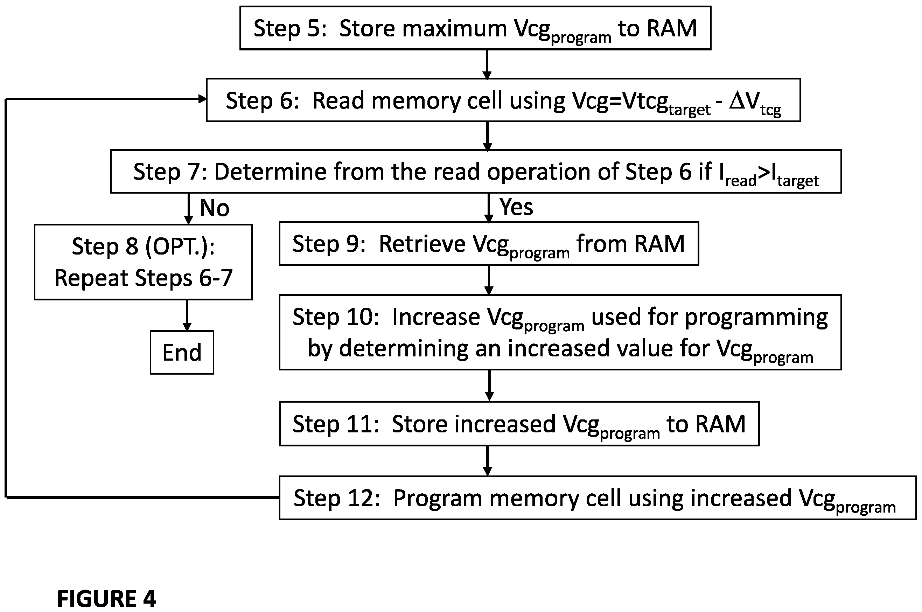

The post-program tuning technique involves the control circuitry 66 implementing memory cell initial programming, followed by post-program tuning for memory cells that exhibit an intolerable level of read current instability after initial programming. Memory cell programming is described first, followed by post-program tuning. Thus, control circuitry 66 may be loaded with software, i.e. non-transitory electronically readable instructions, or firmware, to perform the methods described below in relation to Figs. 4 - 5, thereby being configured. Control circuity 66 may be implemented by a microcontroller, dedicated circuitry, a processor, or a combination thereof.

Memory cell programming involves programming a selected memory cell to an initial programming state using programming voltage pulses, with intervening read operations to measure a threshold voltage parameter (i.e., a minimum voltage applied to the split gate memory cell 10 to achieve a predetermined level of source/drain current, referred to as a target current I_{target}) for the memory cell. The threshold voltage parameter is a control gate threshold voltage Vtcg, which is the threshold voltage of the memory cell as viewed from the control gate 22 (also referred to herein as the first gate). Specifically, the control gate threshold voltage Vtcg is the voltage placed on the control gate 22 that results in the channel region 18 being a conducting path, and therefore results in a read current through the channel of the predetermined level of source/drain current, also known as the target current (I_{target}) (e.g., 1 µA) to consider the memory cell turned on when the read potentials of a read operation are applied to the select gate 24 and drain region 16. The control gate threshold voltage Vtcg varies as a function of programming state of the split gate memory cell 10, but it is desired that once the split gate memory cell 10 is programmed to a particular programming state, any variation of control gate threshold voltage Vtcg over time be below a predetermined amount.

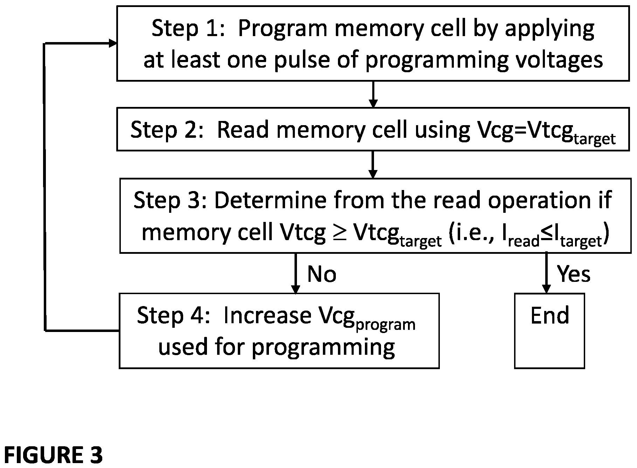

Initial memory cell programming is illustrated as Steps 1-4 in Fig. 3, which is implemented to program a selected split gate memory cell 10 to a specific, desired, initial programming state so that it has a target control gate threshold voltage Vtcg_{target} that is associated with that specific, desired, initial programming state. The technique begins in Step 1 with control circuitry 66 programming a selected split gate memory cell 10 of array 50. As described above, this programming step involves applying programming voltages to the selected split gate memory cell 10 for a limited time (i.e., in at least one pulse), which results in injecting electrons onto the floating gate 20. In the programming of Step 1, the voltage Vcg applied to the control gate 22 has a control gate program voltage Vcg_{program} value. In Step 2, a read operation is performed which involves applying read voltages from for example SLDRV 56 to the selected split gate memory cell 10 and measuring, with column decoder 58 and bit line controller 62, the current flowing through the channel region 18 of the selected split gate memory cell 10, Iread. In this read operation, the voltage Vcg applied to the control gate 22 is the target control gate threshold voltage Vtcg_{target}. In Step 3, it is determined from the read operation of Step 2 whether or not the control gate threshold voltage Vtcg of the memory cell has reached or exceeded the target control gate threshold voltage Vtcg_{target} (i.e., whether the read current I_{read} measured by column decoder 58 and bit line controller 62 is less than or equal to the target current I_{target}, where I_{read} equal to the target current I_{target} is indicative of the control gate threshold voltage Vtcg of the memory cell reaching the target control gate threshold voltage Vtcg_{target}). Read current I_{read} for Step 3 is also referred to herein as the second read current. If the determination is no (i.e., that the control gate threshold voltage Vtcg is not greater than or equal to the target control gate threshold voltage Vtcg_{target}), then in Step 4 the control gate program voltage Vcg_{program} used for programming is increased relative to that used in the previous Step 1 programming of the memory cell, and then Step 1 is repeated using the increased control gate program voltage Vcg_{program}. Steps 1-4 are repeated, in order, by control circuitry 66, until it is determined in Step 3 that the control gate threshold voltage Vtcg of the memory cell has reached or exceeded the target control gate threshold voltage Vtcg_{target} (i.e., that the read current I_{read} is less than or equal to the target current I_{target}). At that point, the memory cell is considered programmed to its desired, initial programming state (i.e. to its target control gate threshold voltage Vtcg_{target}). It is at this point where conventional programming usually ends.

However, if the programmed memory cell exhibits RTN after programming is completed, then electron(s) captured in interface trap(s) contribute to the measured control gate threshold voltage Vtcg of the memory cell as part of programming. If/when the electron(s) are emitted from the interface trap(s) after programming has ended, then the control gate threshold voltage Vtcg could drop by more than ΔVtcgₘₐₓ below the target control gate threshold voltage Vtcg_{target}, where ΔVtcgₘₐₓ is the maximum tolerable read error in terms of control gate threshold voltage Vtcg variation. A control gate threshold voltage drop by more than ΔVtcgₘₐₓ is considered to be an intolerable error during subsequent read operations. Therefore, post-program tuning begins with Step 5 in Fig. 4, where the maximum control gate program voltage Vcg_{program} value (also referred to herein as the first value) that was used in programming the memory cell (also referred to herein as the program voltage) is stored in memory (i.e., the last control gate program voltage Vcg_{program} value used in programming the particular split gate memory cell, i.e., the last iteration of Step 4, unless the initial control gate program voltage Vcg_{program} of Step 1 resulted in the control gate threshold voltage Vtcg of the memory cell reaching or exceeding the target control gate threshold voltage Vtcg_{target} (i.e., that the read current I_{read} is less than or equal to the target current I_{target}), in which case the initial control gate program voltage Vcg_{program} of Step 1 is the maximum control gate program voltage Vcg_{program} value). In one example, the memory used to store the maximum Vcg_{program} value is RAM 70 if post-program tuning is performed just after analog programming. However, if a user intends to perform post-program tuning sometime after analog programming, the maximum control gate program voltage Vcg_{program} values can instead be stored in a file (e.g., in a non-volatile storage, accessible by control circuitry 66) to save the data for a longer period of time. Storing the maximum control gate program voltage Vcg_{program} value is performed by control circuitry 66 after the split gate memory cell 10 is found to be programmed to its desired initial program state, as described above in relation to Step 3.

In Step 6, the split gate memory cell 10 is read (also referred to herein as a first read operation) using a control gate voltage Vcg that is less than the target control gate threshold voltage Vtcg_{target} used in Step 2. Specifically, the control gate voltage Vcg used for this read operation is Vtcg_{target} - ΔV_{tcg}, where ΔV_{tcg} can be, but need not be, the maximum tolerable deviation of control gate threshold voltage (ΔVtcgₘₐₓ). As a non-limiting example, ΔV_{tcg} can be, for example, 20 mV. In Step 7, it is determined from the read operation of Step 6 whether or not the read current I_{read} is greater than the target read current I_{target}. Read current I_{read} for Step 6 is also referred to herein as the first read current. If the memory cell does not exhibit post-program intolerable RTN, then the small decrease in control gate voltage Vcg by ΔV_{tcg} during the read operation of Step 6 should lower the read current I_{read} below, or further below, I_{target}, and the determination of Step 7 should be no, i.e. negative. In that case, the memory cell can be considered properly programmed and no post-program tuning is needed. However, as indicated in optional Step 8, Steps 6 and 7 can be repeated one or more times (where the repeated read operation is also referred to herein as a second read operation), whereby the memory cell will be subjected to another round of programming, as will be described below, if there is a positive determination in Step 7 no matter how many previous negative determinations occurred. Repeating Steps 6-7 even if the result in Step 7 is initially negative is advantageous because an electron may not necessarily be emitted from the trap before the first read, but could be emitted from the trap after the first read, and a yes, or positive, determination in Step 7 can occur in subsequent read operations if there is an electron emission after the first read operation.

If the memory cell does exhibit intolerable RTN, and if before or during this read operation there is interface trap electron emission, then the control gate threshold voltage Vtcg of the memory cell will drop, resulting in a rise in read current I_{read}. If that rise in current exceeds I_{target}, then the determination of Step 7 will be yes, i.e. positive, and the selected split gate memory cell 10 is subjected to another round of programming starting at Step 9, where the maximum control gate program voltage Vcg_{program} value stored in Step 5, i.e. in RAM 70 (or other memory) is retrieved. The retrieved control gate program voltage Vcg_{program} value is increased in preparation for use in programming (see Step 10) (e.g., by determining a control gate program voltage Vcg_{program} of increased value, also referred to herein as the second value), and the determined increased control gate program voltage Vcg_{program} value is stored in RAM 70 (or other memory) (see Step 11). The memory cell is then programmed in Step 12 (similar to Step 1 described above) using the increased control gate program voltage Vcg_{program} value. The process then reverts back to Step 6, where the memory cell is once again read as described above with respect to Step 6, followed by the determination of Step 7 as described above. If the subsequent determination in Step 7 is yes, i.e. positive, Steps 9-12 are performed again, followed by another read in Step 6 and determination in Step 7. If the subsequent determination in Step 7 is no, i.e. negative, post program tuning can end, or, steps 6-7 can be repeated one or more times as indicated in optional Step 8, even though Steps 9-12 may have been performed one or more times. There is no limitation on the number of read and determination operations (Steps 6-7) and on the number of rounds of programming (Steps 9-12). The number of times that Steps 6-7 and 9-12 are repeated can be user defined by taking into account desired programming time. The post-programing tuning process can also be repeated at a time after a previous instance of post-programming tuning, in which case the increased control gate program voltage Vcg_{program} value can be stored in a more permanent memory such as a hard drive or other non-volatile storage, accessible by control circuitry 66, for longer term storage.

The advantage of the above described technique is that if the memory cell exhibits intolerable RTN after programming is initially completed, then it will still end up being more deeply programmed (i.e. exhibit a higher control gate threshold voltage Vtcg) than would otherwise be the case, so that the control gate threshold voltage Vtcg will not vary from the target control gate threshold voltage Vteg_{target} by an undesired amount. By utilizing the above described technique, even if electron emission occurs, it is less likely that the control gate threshold voltage Vtcg of the split gate memory cell 10 will drop below the target control gate threshold voltage Vtcg_{target} by an amount exceeding the tolerance level of ΔV_{tcg}. This is because the split gate memory cell 10 is more deeply programmed above Vtcg_{target} and future read operations will more accurately reflect the desired programming state of the memory cell within the tolerance level of ΔV_{tcg} variations.

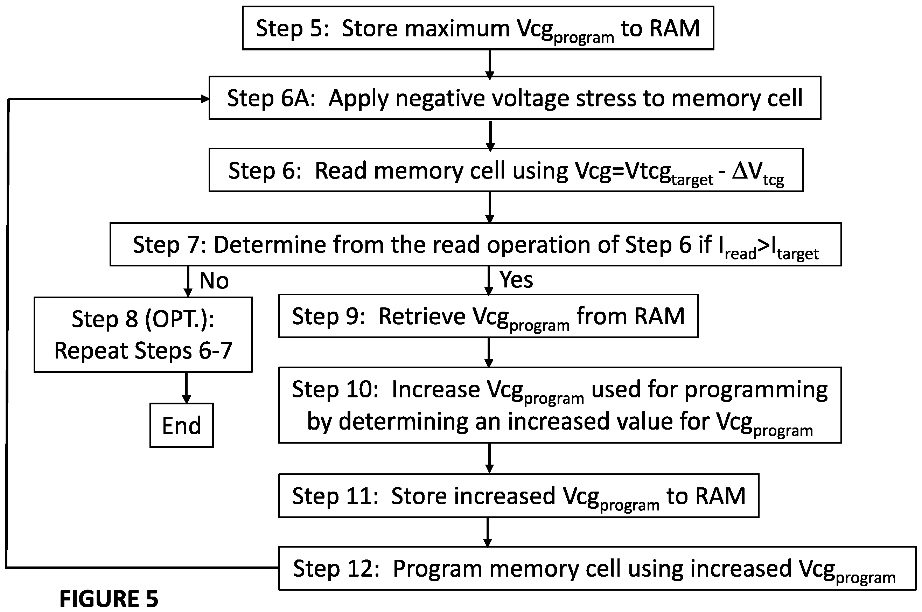

Fig. 5 illustrates a first alternate example, which is the same method as that described above and depicted in Figs. 3-4, and will not be described again, except Step 6A is added before Step 6, and after Step 12 the process reverts to Step 6A instead of to Step 6. Specifically, before the memory cell is read in Step 6, a negative voltage is applied to the memory cell sourced from for example SLDRV 56 under the control of control circuitry 66 (e.g. to any non-floating gate of the memory cell, such as the control gate 22, erase gate 26, and/or select gate 24), with the negative voltage defined in relation to the potential of substrate 12. This negative voltage applied to the split gate memory cell 10 induces electric field stress on the gate oxide of the split gate memory cell 10 to stimulate detrapping (emission) of electrons from the interface and near-interface oxide traps. In one example, the negative voltage is applied to the control gate 22, but it can additionally or alternatively be applied to any gate or terminal that is capacitively coupled to the floating gate 20. Therefore, for a split gate memory cell 10 that has an oxide trap which produces RTN, the negative voltage will help stimulate detrapping of electron, setting the control gate threshold voltage Vtcg to a lower threshold voltage Vt state, and increasing the chances that the determination of Step 7 will be positive (and therefore the memory cell will be subjected to additional programming). Since RTN has an erratic behavior, a defective memory cell may stay in one control gate threshold voltage Vtcg state even during the read operation of Step 6, and it will therefore not be properly identified for additional programming of steps 9 - 12. Therefore, application of a negative voltage (e.g., -1 V to -7 V) before the read operation of Step 6 may stimulate a memory cell with RTN to exhibit a lower control gate threshold voltage Vtcg state and, thereby, be identified in Step 7 for additional programming, enhancing programming efficiency and accuracy. There is some characteristic time during which memory cells maintain their control gate threshold voltage Vtcg state acquired under the applied voltage stress after its removal. Therefore, the delay between the negative voltage application of Step 6A and the read operation of Step 6 is in one example not longer than typical electron capture and emission time (100 ms at room temperature, as an example), otherwise, application of the negative voltage of step 6A prior to the read operation of step 6 may be less efficient.

It is to be understood that the above is not limited to the examples(s) described above and illustrated herein but encompasses any and all variations falling within the scope of any claims. For example, any references to the examples or invention herein are not intended to limit the scope of any claim or claim term, but instead merely relate to one or more features that may be covered by one or more of the claims. Materials, processes and numerical examples described above are examples only, and should not be deemed to limit the claims. Further, as is apparent from any claims and the specification, not all method steps need be performed in the exact order illustrated or claimed unless specified. The example of threshold voltage Vtcg used in the above described techniques is the threshold voltage of the memory cell as viewed from the control gate 22. However, the above described techniques could be implemented with respect to threshold voltage Vt as viewed from any one or more gates in the split gate memory cell 10 that is not floating. Additionally, the descriptions above could be implemented in an array of memory cells with fewer gates than those in Fig. 1 (e.g., no erase gate and/or control gate combined with select gate).

## Claims

1. A memory device, comprising:
a plurality of non-volatile memory cells each comprising a first gate; and
a control circuitry configured to:
program a selected non-volatile memory cell of the plurality of non-volatile memory cells to an initial program state that corresponds to a threshold voltage for the first gate of the selected non-volatile memory cell meeting or exceeding a target threshold voltage for the first gate of the selected non-volatile memory cell, wherein the target threshold voltage for the first gate corresponds to a target read current, wherein the programing of the selected non-volatile memory cell includes apply a program voltage having a first value to the first gate,
store the first value in a memory,
read the selected non-volatile memory cell in a first read operation using a read voltage applied to the first gate of the selected non-volatile memory cell that is less than the target threshold voltage for the first gate to generate a first read current, and
subject the selected non-volatile memory cell to additional programming in response to a determination that the first read current is greater than the target read current, wherein the additional programming comprises:
retrieve the first value from the memory,
determine a second value greater than the first value, and
program the selected non-volatile memory cell that includes applying a program voltage having the second value to the first gate.

2. The memory device of claim 1, wherein the control circuitry is configured to store the second value in the memory.

3. The memory device of claim 1, wherein the control circuitry is configured to program of the selected non-volatile memory cell to the initial program state by:
apply at least one first pulse of programming voltages to the selected non-volatile memory cell;
read the selected non-volatile memory cell using a read voltage applied to the first gate of the selected non-volatile memory cell that is equal to the target threshold voltage for the first gate to generate a second read current; and
apply at least one second pulse of programming voltages to the selected non-volatile memory cell in response to a determination that the second read current is not less than or equal to the target read current.

4. The memory device of claim 1, wherein the control circuitry is configured to:
read the selected non-volatile memory cell in a second read operation performed, in response to a determination that the first read current is not greater than the target read current in the first read operation, using a read voltage applied to the first gate of the selected non-volatile memory cell that is less than the target threshold voltage to generate a second read current, and
subject the selected non-volatile memory cell to the additional programming in response to a determination that the second read current is greater than the target read current; and
not subject the selected non-volatile memory cell to the additional programming in response to a determination that the second read current is not greater than the target read current.

5. The memory device of claim 1, wherein the control circuitry is configured to apply a negative voltage to a non-floating gate of the selected non-volatile memory cell after the programming of the selected non-volatile memory cell to the initial program state and before the first read operation, and/or
wherein the control circuitry is configured to apply a negative voltage to the first gate of the selected non-volatile memory cell after the programming of the selected non-volatile memory cell to the initial program state and before the first read operation.

6. The memory device of claim 4, wherein the control circuitry is configured to:
apply a negative voltage to the first gate of the selected non-volatile memory cell after the programming of the selected non-volatile memory cell to the initial program state and before the first read operation; and
apply a negative voltage to the first gate of the selected non-volatile memory cell after the determining that the first read current is not greater than the target read current in the first read operation and before the second read operation.

7. A method of programming a selected non-volatile memory cell of a plurality of non-volatile memory cells, wherein each of the plurality of non-volatile memory cells includes a first gate, the method comprising:
programming the selected non-volatile memory cell to an initial program state that corresponds to meeting or exceeding a target threshold voltage for the first gate of the selected non-volatile memory cell, wherein the target threshold voltage corresponds to a target read current, wherein the programing includes applying a program voltage having a first value to the first gate,
storing the first value in a memory,
reading the selected non-volatile memory cell in a first read operation using a read voltage applied to the first gate of the selected non-volatile memory cell that is less than the target threshold voltage to generate a first read current, and
subjecting the selected non-volatile memory cell to additional programming in response to determining that the first read current is greater than the target read current, wherein the additional programming comprises:
retrieving the first value from the memory,
determining a second value greater than the first value, and
programming the selected non-volatile memory cell that includes applying a program voltage having the second value to the first gate.

8. The method of claim 7, comprising:
storing the second value in the memory.

9. The memory device of claim 1 or the method of claim 7, wherein each of the plurality of non-volatile memory cells further comprises:
spaced apart source and drain regions formed in a semiconductor substrate, with a channel region of the substrate extending there between;
a floating gate disposed vertically over and insulated from a first portion of the channel region; and
a select gate disposed vertically over and insulated from a second portion of the channel region;
wherein for each of the plurality of non-volatile memory cells, the first gate is disposed vertically over and insulated from the floating gate.

10. The memory device of claim 1 or the method of claim 9, wherein each of the plurality of non-volatile memory cells further comprises:
an erase gate disposed over and insulated from the source region.

11. The method of claim 7, wherein the programming of the selected non-volatile memory cell to the initial program state comprises:
applying at least one first pulse of programming voltages to the selected non-volatile memory cell;
reading the selected non-volatile memory cell using a read voltage applied to the first gate of the selected non-volatile memory cell that is equal to the target threshold voltage to generate a second read current; and
applying at least one second pulse of programming voltages to the selected non-volatile memory cell in response to determining that the second read current is greater than the target read current.

12. The memory device of claim 3 or the method of claim 11, wherein the at least one first pulse of programming voltages includes a first program voltage applied to the first gate, and the at least one second pulse of programming voltages includes a second program voltage applied to the first gate that is greater than the first program voltage.

13. The method of claim 7, comprising:
reading the selected non-volatile memory cell in a second read operation performed, in response to determining that the first read current is not greater than the target read current in the first read operation, using a read voltage applied to the first gate of the selected non-volatile memory cell that is less than the target threshold voltage to generate a second read current, and
subjecting the selected non-volatile memory cell to the additional programming in response to determining that the second read current is greater than the target read current; and
not subjecting the selected non-volatile memory cell to the additional programming in response to determining that the second read current is not greater than the target read current.

14. The method of claim 7, further comprising:
applying a negative voltage to a non-floating gate of the selected non-volatile memory cell after the programming of the selected non-volatile memory cell to the initial program state and before the first read operation, and/or
further comprising:
applying a negative voltage to the first gate of the selected non-volatile memory cell after the programming of the selected non-volatile memory cell to the initial program state and before the first read operation.

15. The method of claim 13, comprising:
applying a negative voltage to the first gate of the selected non-volatile memory cell after the programming of the selected non-volatile memory cell to the initial program state and before the first read operation; and
applying a negative voltage to the first gate of the selected non-volatile memory cell after the determining that the first read current is not greater than the target read current in the first read operation and before the second read operation.

## Patentansprüche

1. Speichervorrichtung, umfassend:
eine Vielzahl von nichtflüchtigen Speicherzellen, jeweils umfassend ein erstes Gate; und
eine Steuerschaltung, die konfiguriert ist zum:
Programmieren einer ausgewählten nichtflüchtigen Speicherzelle der Vielzahl von nichtflüchtigen Speicherzellen auf einen anfänglichen Programmzustand, der einer Schwellenspannung für das erste Gate der ausgewählten nichtflüchtigen Speicherzelle entspricht, die eine Zielschwellenspannung für das erste Gate der ausgewählten nichtflüchtigen Speicherzelle erreicht oder überschreitet, wobei die Zielschwellenspannung für das erste Gate einem Ziellesestrom entspricht, wobei das Programmieren der ausgewählten nichtflüchtigen Speicherzelle ein Anlegen einer Programmspannung einschließt, die einen ersten Wert aufweist, an das erste Gate,
Speichern des ersten Werts in einem Speicher,
Lesen der ausgewählten nichtflüchtigen Speicherzelle in einem ersten Lesevorgang unter Verwendung einer Lesespannung, die an das erste Gate der ausgewählten nichtflüchtigen Speicherzelle angelegt wird, die kleiner als die Zielschwellenspannung für das erste Gate ist, um einen ersten Lesestrom zu erzeugen, und
Unterziehen der ausgewählten nichtflüchtigen Speicherzelle dem zusätzlichen Programmieren als Reaktion auf eine Bestimmung, dass der erste Lesestrom größer als der Ziellesestrom ist, wobei das zusätzliche Programmieren umfasst:
Abrufen des ersten Werts aus dem Speicher,
Bestimmen eines zweiten Wertes, der größer als der erste Wert ist, und
Programmieren der ausgewählten nichtflüchtigen Speicherzelle, die ein Anlegen einer Programmspannung einschließt, die den zweiten Wert aufweist, an das erste Gate.

2. Speichervorrichtung nach Anspruch 1, wobei die Steuerschaltung konfiguriert ist, um den zweiten Wert in dem Speicher zu speichern.

3. Speichervorrichtung nach Anspruch 1, wobei die Steuerschaltung konfiguriert ist, um die ausgewählte nichtflüchtige Speicherzelle in den anfänglichen Programmzustand zu programmieren durch:
Anlegen von mindestens einem ersten Impuls von Programmierspannungen an die ausgewählte nichtflüchtige Speicherzelle;
Lesen der ausgewählten nichtflüchtigen Speicherzelle unter Verwendung einer Lesespannung, die an das erste Gate der ausgewählten nichtflüchtigen Speicherzelle angelegt wird, die gleich der Zielschwellenspannung für das erste Gate ist, um einen zweiten Lesestrom zu erzeugen; und
Anlegen von mindestens einem zweiten Impuls von Programmierspannungen an die ausgewählte nichtflüchtige Speicherzelle als Reaktion auf eine Bestimmung, dass der zweite Lesestrom nicht kleiner als oder gleich des Ziellesestroms ist.

4. Speichervorrichtung nach Anspruch 1, wobei die Steuerschaltung konfiguriert ist zum:
Lesen der ausgewählten nichtflüchtigen Speicherzelle in einem zweiten durchgeführten Lesevorgang als Reaktion auf eine Bestimmung, dass der erste Lesestrom nicht größer als der Ziellesestrom in dem ersten Lesevorgang ist, unter Verwendung einer Lesespannung, die an das erste Gate der ausgewählten nichtflüchtigen Speicherzelle angelegt wird, die kleiner als die Zielschwellenspannung ist, um einen zweiten Lesestrom zu erzeugen, und
Unterziehen der ausgewählten nichtflüchtigen Speicherzelle dem zusätzlichen Programmieren als Reaktion auf eine Bestimmung, dass der zweite Lesestrom größer als der Ziellesestrom ist; und
nicht Unterziehen der ausgewählten nichtflüchtigen Speicherzelle dem zusätzlichen Programmieren als Reaktion auf eine Bestimmung, dass der zweite Lesestrom nicht größer als der Ziellesestrom ist.

5. Speichervorrichtung nach Anspruch 1, wobei die Steuerschaltung konfiguriert ist, um nach dem Programmieren der ausgewählten nichtflüchtigen Speicherzelle in den anfänglichen Programmzustand und vor dem ersten Lesevorgang eine negative Spannung an ein Non-Floating-Gate der ausgewählten nichtflüchtigen Speicherzelle anzulegen, und/oder
wobei die Steuerschaltung konfiguriert ist, um nach dem Programmieren der ausgewählten nichtflüchtigen Speicherzelle in den anfänglichen Programmzustand und vor dem ersten Lesevorgang eine negative Spannung an das erste Gate der ausgewählten nichtflüchtigen Speicherzelle anzulegen.

6. Speichervorrichtung nach Anspruch 4, wobei die Steuerschaltung ferner konfiguriert ist zum:
Anlegen einer negativen Spannung an das erste Gate der ausgewählten nichtflüchtigen Speicherzelle nach dem Programmieren der ausgewählten nichtflüchtigen Speicherzelle in den anfänglichen Programmzustand und vor dem ersten Lesevorgang; und
Anlegen einer negativen Spannung an das erste Gate der ausgewählten nichtflüchtigen Speicherzelle nach dem Bestimmen, dass der erste Lesestrom nicht größer als der Ziellesestrom in dem ersten Lesevorgang und vor dem zweiten Lesevorgang ist.

7. Verfahren zum Programmieren einer ausgewählten nichtflüchtigen Speicherzelle aus einer Vielzahl von nichtflüchtigen Speicherzellen, wobei jede der Vielzahl von nichtflüchtigen Speicherzellen ein erstes Gate einschließt, das Verfahren umfassend:
Programmieren der ausgewählten nichtflüchtigen Speicherzelle in einen anfänglichen Programmzustand, der dem Erreichen oder dem Überschreiten einer Zielschwellenspannung für das erste Gate der ausgewählten nichtflüchtigen Speicherzelle entspricht, wobei die Zielschwellenspannung einem Ziellesestrom entspricht, wobei das Programmieren das Anlegen einer Programmspannung einschließt, die einen ersten Wert aufweist, an das erste Gate,
Speichern des ersten Wertes in einem Speicher,
Lesen der ausgewählten nichtflüchtigen Speicherzelle in einem ersten Lesevorgang unter Verwendung einer Lesespannung, die an das erste Gate der einen nichtflüchtigen Speicherzelle angelegt wird, die kleiner als die Zielschwellenspannung ist, um den ausgewählten ersten Lesestrom zu erzeugen, und
Unterziehen der ausgewählten nichtflüchtigen Speicherzelle dem zusätzlichen Programmieren als Reaktion auf ein Bestimmen, dass der erste Lesestrom größer als der Ziellesestrom ist, wobei das zusätzliche Programmieren umfasst:
Abrufen des ersten Wertes aus dem Speicher,
Bestimmen eines zweiten Werts, der größer als der erste Wert ist, und
Programmieren der ausgewählten nichtflüchtigen Speicherzelle, das das Anlegen einer Programmspannung einschließt, die den zweiten Wert an das erste Gate aufweist.

8. Verfahren nach Anspruch 7, umfassend:
Speichern des zweiten Werts in dem Speicher.

9. Speichervorrichtung nach Anspruch 1 oder Verfahren nach Anspruch 7, wobei jede der Vielzahl von nichtflüchtigen Speicherzellen ferner umfasst:
voneinander beabstandete Source- und Drain-Regionen, die in einem Halbleitersubstrat ausgebildet sind, wobei sich eine Kanalregion des Substrats dazwischen erstreckt;
ein Floating-Gate, das über einem ersten Abschnitt der Kanalregion vertikal angeordnet und von diesem isoliert ist; und
ein Auswahl-Gate, das über einem zweiten Abschnitt der Kanalregion vertikal angeordnet und von diesem isoliert ist;
wobei für jede der Vielzahl von nichtflüchtigen Speicherzellen das erste Gate über dem Floating-Gate vertikal angeordnet und von diesem isoliert ist.

10. Speichervorrichtung nach Anspruch 1 oder Verfahren nach Anspruch 9, wobei jede der Vielzahl von nichtflüchtigen Speicherzellen ferner umfasst:
ein Lösch-Gate, das über der Source-Region angeordnet und von dieser isoliert ist.

11. Verfahren nach Anspruch 7, wobei das Programmieren der ausgewählten nichtflüchtigen Speicherzelle in den anfänglichen Programmzustand umfasst:
Anlegen von mindestens einem ersten Impuls von Programmierspannungen an die eine nichtflüchtige Speicherzelle;
Lesen der ausgewählten nichtflüchtigen Speicherzelle unter Verwendung einer Lesespannung, die an das erste Gate der ausgewählten nichtflüchtigen Speicherzelle angelegt wird, die gleich der Zielschwellenspannung ist, um einen zweiten Lesestrom zu erzeugen; und
Anlegen von mindestens einem zweiten Impuls von Programmierspannungen an die ausgewählte nichtflüchtige Speicherzelle als Reaktion auf das Bestimmen, dass der zweite Lesestrom größer als der Ziellesestrom ist.

12. Speichervorrichtung nach Anspruch 3 oder Verfahren nach Anspruch 11, wobei der mindestens eine erste Impuls von Programmspannungen eine erste Programmspannung einschließt, die an das erste Gate angelegt wird, und der mindestens eine zweite Impuls von Programmierspannungen eine zweite Programmspannung einschließt, die an das erste Gate angelegt wird und die größer als die erste Programmspannung ist.

13. Verfahren nach Anspruch 7, umfassend:
Lesen der ausgewählten nichtflüchtigen Speicherzelle in einem zweiten durchgeführten Lesevorgang als Reaktion auf das Bestimmen, dass der erste Lesestrom nicht größer als der Ziellesestrom in dem ersten Lesevorgang ist, unter Verwendung einer Lesespannung, die an das erste Gate der ausgewählten nichtflüchtigen Speicherzelle angelegt wird, die kleiner als die Zielschwellenspannung ist, um einen zweiten Lesestrom zu erzeugen, und
Unterziehen der ausgewählten nichtflüchtigen Speicherzelle dem zusätzlichen Programmieren als Reaktion auf das Bestimmen, dass der zweite Lesestrom größer als der Ziellesestrom ist; und
nicht Unterziehen der ausgewählten nichtflüchtigen Speicherzelle dem zusätzlichen Programmieren als Reaktion auf das Bestimmen, dass der zweite Lesestrom größer als der Ziellesestrom ist.

14. Verfahren nach Anspruch 7, ferner umfassend:
Anlegen einer negativen Spannung an das Non-Floating-Gate der ausgewählten nichtflüchtigen Speicherzelle nach dem Programmieren der ausgewählten nichtflüchtigen Speicherzelle in den anfänglichen Programmzustand und vor dem ersten Lesevorgang, und/oder
ferner umfassend:
Anlegen einer negativen Spannung an das erste Gate der ausgewählten nichtflüchtigen Speicherzelle nach dem Programmieren der ausgewählten nichtflüchtigen Speicherzelle in den anfänglichen Programmzustand und vor dem ersten Lesevorgang.

15. Verfahren nach Anspruch 13, umfassend:
Anlegen einer negativen Spannung an das erste Gate der ausgewählten nichtflüchtigen Speicherzelle nach dem Programmieren der ausgewählten nichtflüchtigen Speicherzelle in den anfänglichen Programmzustand und vor dem ersten Lesevorgang; und
Anlegen einer negativen Spannung an das erste Gate der ausgewählten nichtflüchtigen Speicherzelle nach dem Bestimmen, dass der erste Lesestrom nicht größer als der Ziellesestrom in dem ersten Lesevorgang und vor dem zweiten Lesevorgang ist.

## Revendications

1. Dispositif de mémoire, comprenant :
une pluralité de cellules de mémoire non volatile comprenant chacune une première grille ; et
une circuiterie de commande configurée pour :
programmer une cellule de mémoire non volatile sélectionnée de la pluralité de cellules de mémoire non volatile à un état de programme initial qui correspond à une tension seuil, pour la première grille de la cellule de mémoire non volatile sélectionnée, atteignant ou dépassant une tension seuil cible pour la première grille de la cellule de mémoire non volatile sélectionnée, dans lequel la tension seuil cible pour la première grille correspond à un courant de lecture cible, dans lequel la programmation de la cellule de mémoire non volatile sélectionnée comporte l'application d'une tension de programme ayant une première valeur à la première grille,
stocker la première valeur dans une mémoire,
lire la cellule de mémoire non volatile sélectionnée lors d'une première opération de lecture à l'aide d'une tension de lecture appliquée à la première grille de la cellule de mémoire non volatile sélectionnée qui est inférieure à la tension seuil cible pour la première grille afin de générer un premier courant de lecture, et
soumettre la cellule de mémoire non volatile sélectionnée à une programmation supplémentaire en réponse au fait de déterminer que le premier courant de lecture est supérieur au courant de lecture cible, dans lequel la programmation supplémentaire comprend :
la récupération de la première valeur de la mémoire,
la détermination d'une seconde valeur supérieure à la première valeur, et
la programmation de la cellule de mémoire non volatile sélectionnée qui comporte l'application d'une tension de programmation ayant la seconde valeur à la première grille.

2. Dispositif de mémoire selon la revendication 1, dans lequel la circuiterie de commande est configurée pour stocker la seconde valeur dans la mémoire.

3. Dispositif selon la revendication 1, dans lequel la circuiterie de commande est configurée pour programmer la cellule de mémoire non volatile à l'état de programme initial par :
l'application d'au moins une première impulsion de tensions de programmation à la cellule de mémoire non volatile sélectionnée ;
la lecture de la cellule de mémoire non volatile sélectionnée à l'aide d'une tension de lecture appliquée à la première grille de la cellule de mémoire non volatile sélectionnée qui est égale à la tension seuil cible pour la première grille afin de générer un second courant de lecture ; et
l'application d'au moins une seconde impulsion de tensions de programmation à la cellule de mémoire non volatile sélectionnée en réponse au fait de déterminer que le second courant de lecture n'est pas inférieur ou égal au courant de lecture cible.

4. Dispositif de mémoire selon la revendication 1, dans lequel la circuiterie de commande est configurée pour :
lire la cellule de mémoire non volatile sélectionnée lors d'une seconde opération de lecture réalisée, en réponse au fait de déterminer que le premier courant de lecture n'est pas supérieur au courant de lecture cible lors de la première opération de lecture, à l'aide d'une tension de lecture appliquée à la première grille de la cellule de mémoire non volatile sélectionnée qui est inférieure à la tension seuil cible pour générer un second courant de lecture, et
soumettre la cellule de mémoire non volatile sélectionnée à une programmation supplémentaire en réponse au fait de déterminer que le second courant de lecture est supérieur au courant de lecture cible ; et
ne pas soumettre la cellule de mémoire non volatile sélectionnée à la programmation supplémentaire en réponse au fait de déterminer que le second courant de lecture n'est pas supérieur au courant de lecture cible.

5. Dispositif selon la revendication 1, dans lequel la circuiterie de commande est en outre configurée pour appliquer une tension négative à une grille non-flottante de la cellule de mémoire non volatile sélectionnée après la programmation de la cellule de mémoire non volatile sélectionnée à l'état de programme initial et avant la première opération de lecture, et/ou
dans lequel la circuiterie de commande est en outre configurée pour appliquer une tension négative à la première grille de la cellule de mémoire non volatile sélectionnée après la programmation de la cellule de mémoire non volatile sélectionnée à l'état de programme initial et avant la première opération de lecture.

6. Dispositif de mémoire selon la revendication 4, dans lequel la circuiterie de commande est configurée pour :
appliquer une tension négative à la première grille de la cellule de mémoire non volatile sélectionnée après la programmation de la cellule de mémoire non volatile sélectionnée à l'état de programme initial et avant la première opération de lecture ; et
appliquer une tension négative à la première grille de la cellule de mémoire non volatile sélectionnée après le fait de déterminer que le premier courant de lecture n'est pas supérieur au courant de lecture cible lors de la première opération de lecture et avant la seconde opération de lecture.

7. Procédé de programmation d'une cellule de mémoire non volatile sélectionnée d'une pluralité de cellules de mémoire non volatile, dans lequel chacune de la pluralité de cellules de mémoire non volatile comporte une première grille, le procédé comprenant :
la programmation de la cellule de mémoire non volatile sélectionnée à un état de programme initial qui correspond à l'atteinte ou au dépassement d'une tension seuil cible pour la première grille de la cellule de mémoire non volatile sélectionnée, dans lequel la tension seuil cible correspond à un courant de lecture cible, dans lequel la programmation comporte l'application d'une tension de programme ayant une première valeur à la première grille,
le stockage de la première valeur dans une mémoire,
la lecture de la cellule de mémoire non volatile sélectionnée lors d'une première opération de lecture à l'aide d'une tension de lecture appliquée à la première grille de la cellule de mémoire non volatile sélectionnée qui est inférieure à la tension seuil cible pour générer un premier courant de lecture, et
la soumission de la cellule de mémoire non volatile sélectionnée à une programmation supplémentaire en réponse au fait de déterminer que le premier courant de lecture est supérieur au courant de lecture cible, dans lequel la programmation supplémentaire comprend :
la récupération de la première valeur de la mémoire,
la détermination d'une seconde valeur supérieure à la première valeur, et
la programmation de la cellule de mémoire non volatile sélectionnée qui comporte l'application d'une tension de programme ayant la seconde valeur à la première grille.

8. Procédé selon la revendication 7, comprenant :
le stockage de la seconde valeur dans la mémoire.

9. Dispositif selon la revendication 1 ou procédé selon la revendication 7, dans lequel chacune de la pluralité de cellules de mémoire non volatile comprend en outre :
des régions de source et de drain espacées formées dans un substrat semi-conducteur, avec une région de canal du substrat s'étendant entre elles ;
une grille flottante disposée verticalement au-dessus et isolée d'une première partie de la région de canal ; et
une grille de sélection disposée verticalement au-dessus et isolée d'une seconde partie de la région de canal ;
dans lequel, pour chacune de la pluralité de cellules de mémoire non volatile, la première grille est disposée verticalement au-dessus et isolée de la grille flottante.

10. Dispositif selon la revendication 1 ou procédé selon la revendication 9, dans lequel chacune de la pluralité de cellules de mémoire non volatile comprend en outre :
une grille d'effacement disposée au-dessus et isolée de la région de source.

11. Procédé selon la revendication 7, dans lequel la programmation de la cellule de mémoire non volatile sélectionnée à l'état de programme initial comprend :
l'application d'au moins une première impulsion de tensions de programmation à la cellule de mémoire non volatile sélectionnée ;
la lecture de la cellule de mémoire non volatile sélectionnée à l'aide d'une tension de lecture appliquée à la première grille de la cellule de mémoire non volatile sélectionnée qui est égale à la tension seuil cible pour générer un second courant de lecture ; et
l'application d'au moins une seconde impulsion de tensions de programmation à la cellule de mémoire non volatile sélectionnée en réponse au fait de déterminer que le second courant de lecture est supérieur au courant de lecture cible.

12. Dispositif de mémoire selon la revendication 3 ou procédé selon la revendication 11, dans lequel l'au moins une première impulsion de tensions de programmation comporte une première tension de programme appliquée à la première grille, et l'au moins une seconde impulsion de tensions de programmation comporte une seconde tension de programme appliquée à la première grille qui est supérieure à la première tension de programme.

13. Procédé selon la revendication 7, comprenant :
la lecture de la cellule de mémoire non volatile sélectionnée lors d'une seconde opération de lecture réalisée, en réponse au fait de déterminer que le premier courant de lecture n'est pas supérieur au courant de lecture cible lors de la première opération de lecture, à l'aide d'une tension de lecture appliquée à la première grille de la cellule de mémoire non volatile sélectionnée qui est inférieure à la tension seuil cible pour générer un second courant de lecture, et
la soumission de la cellule de mémoire non volatile sélectionnée à la programmation supplémentaire en réponse au fait de déterminer que le second courant de lecture est supérieur au courant de lecture cible ; et
la non soumission de la cellule de mémoire non volatile sélectionnée à la programmation supplémentaire en réponse au fait de déterminer que le second courant de lecture n'est pas supérieur au courant de lecture cible.

14. Procédé selon la revendication 7, comprenant en outre :
l'application d'une tension négative à une grille non-flottante de la cellule de mémoire non volatile sélectionnée après la programmation de la cellule de mémoire non volatile sélectionnée à l'état de programme initial et avant la première opération de lecture, et/ou
comprenant en outre :
l'application d'une tension négative à la première grille de la cellule de mémoire non volatile sélectionnée après la programmation de la cellule de mémoire non volatile sélectionnée à l'état de programme initial et avant la première opération de lecture.

15. Procédé selon la revendication 13, comprenant :
l'application d'une tension négative à la première grille de la cellule de mémoire non volatile sélectionnée après la programmation de la cellule de mémoire non volatile sélectionnée à l'état de programme initial et avant la première opération de lecture ; et
l'application d'une tension négative à la première grille de la cellule de mémoire non volatile sélectionnée après le fait de déterminer que le premier courant de lecture n'est pas supérieur au courant de lecture cible lors de la première opération de lecture et avant la seconde opération de lecture.
